# EUROPEAN PATENT SPECIFICATION

(11) **EP 4 250 886 B1**
(45) Date of publication and mention of the grant of the patent: **31.12.2025**
(21) Application number: 21893235.8
(22) Date of filing: 12.03.2021
(51) Int. Cl.: F03D 3/00, F03D 9/32, F03D 80/60, B63H 9/02, F04D 25/08, F04D 29/60

(54) **VENTILATION AND HEAT DISSIPATION APPARATUS**
LÜFTUNGS- UND WÄRMEABLEITUNGSVORRICHTUNG
APPAREIL DE VENTILATION ET DE DISSIPATION DE CHALEUR

(30) Priority: 20.11.2020 CN 202011310324
(43) Date of publication of application: 27.09.2023
(73) Proprietor: CSIC Shanghai Marine Energy Saving Technology Development Co., Ltd., Shanghai 200011 (CN)
(72) Inventor: GUO, Fengshan, Shanghai 200011 (CN); WU, Youhua, Shanghai 200011 (CN); ZHU, Yuzhu, Shanghai 200011 (CN); HUANG, Zhenyu, Shanghai 200011 (CN); WU, Zan, Shanghai 200011 (CN); XIA, Haochao, Shanghai 200011 (CN); CHEN, Shaofeng, Shanghai 200011 (CN); ZHAO, Lu, Shanghai 200011 (CN)
(74) Representative: Carangelo, Pierluigi
(86) International application number: PCT/CN2021/080440
(87) International publication number: WO 2022/105077

(56) References cited:
- WO-A2-2009/021485
- CN-A- 110 880 705
- CN-A- 111 786 288
- CN-A- 111 846 175
- CN-A- 112 312 748
- CN-U- 208 986 460
- KR-A- 20140 114 525
- KR-B1- 102 159 714
- TW-B- I 338 766
- US-A1- 2016 280 347

## Description

### TECHNICAL FIELD

The present application relates to the field of heat dissipation technology of wind-assisted rotors and, in particular, to a ventilation and heat dissipation apparatus for a wind-assisted rotor.

### BACKGROUND

Wind-assisted rotors are typically large in size and require sustained operation at relatively high rotational speeds to provide sustained propulsion for ship sailing. An outer cylinder and an inner tower are generally connected by a bearing, and continuous friction generates a large amount of heat. At the same time, a wind-assisted rotor is usually driven by an electric motor inside the tower. To maintain stability, the electric motor is generally placed at a relatively high position. The overall space inside the tower is relatively closed and limited so that a relatively large amount of heat accumulates inside the tower. A high temperature seriously affects the operation stability of the electric motor, affecting the sustained operation of the rotor. A heat dissipation apparatus of a rotor in the related art is generally provided with no ventilation holes or cannot efficiently perform ventilation and heat dissipation, or a heat dissipation solution is too complex, resulting in increased production costs. Further relevant technologies are discussed in the patent application publications: KR 102 159 714 B1, KR 2014 0114525 A, TW I 338 766 B, and US 2016/280347 A1.

### SUMMARY

The present application provides a ventilation and heat dissipation apparatus for a wind-assisted rotor as defined in the attached independent claim, where the apparatus has a simple structure, a low production cost, and a good ventilation and heat dissipation effect and can prevent rain and snow from entering. Further improvements are provided in the dependent claims.

The present application provides a ventilation and heat dissipation apparatus for a wind-assisted rotor, which includes a cylinder, a top cover, and a rain shielding plate.

The top cover is disposed at the top of the cylinder and covers the top of the cylinder, where the top cover is provided with a manhole communicating with an inner cavity of the cylinder.

The rain shielding plate is disposed above the manhole and covering the manhole, where the rain shielding plate and the top cover are spaced apart to form a heat dissipation gap that communicates with the external atmosphere.

### BRIEF DESCRIPTION OF DRAWINGS

FIG. 1 is an assembly drawing of a ventilation and heat dissipation apparatus for a wind-assisted rotor according to embodiment one of the present application.
FIG. 2 is a structural view of part of the structure of a ventilation and heat dissipation apparatus for a wind-assisted rotor according to embodiment one of the present application.
FIG. 3 is a partial enlarged view of the ventilation and heat dissipation apparatus for the wind-assisted rotor in FIG. 2.
FIG. 4 is a schematic view of thermal gas flow inside a cylinder according to embodiment one of the present application.
FIG. 5 is a structural view of part of the structure of a ventilation and heat dissipation apparatus for a wind-assisted rotor according to embodiment two of the present application.
FIG. 6 is a partial enlarged view of the ventilation and heat dissipation apparatus for the wind-assisted rotor in FIG. 5.
FIG. 7 is a structural view of a reinforcement assembly according to embodiment two of the present application.

### Reference list

- 1: manhole
- 2: cylinder
- 3: top cover
- 4: rain shielding plate
- 41: first rain shielding plate
- 42: second rain shielding plate
- 5: support column
- 6: reinforcement assembly
- 61: lining plate
- 611: first lining plate
- 612: second lining plate
- 62: reinforcement rib
- 7: rain blocking boss
- 8: exhaust fan

### DETAILED DESCRIPTION

In the description of the present application, terms "joined", "connected", and "secured" are to be construed in a broad sense unless otherwise expressly specified and limited. For example, the term "connected" may refer to "securely connected", "detachably connected", or "integrated", may refer to "mechanically connected" or "electrically connected", may refer to "connected directly" or "connected indirectly through an intermediary", or may refer to "connected inside two components" or "an interaction relation between two components". For those of ordinary skill in the art, specific meanings of the preceding terms in the present application may be understood based on specific situations.

In the present application, unless otherwise expressly specified and limited, when a first feature is described as "above" or "below" a second feature, the first feature and the second feature may be in direct contact or be in contact via another feature between the two features instead of being in direct contact. Moreover, when the first feature is described as "on", "above", or "over" the second feature, the first feature is right on, above, or over the second feature or the first feature is obliquely on, above, or over the second feature, or the first feature is simply at a higher level than the second feature. When the first feature is described as "under", "below", or "underneath" the second feature, the first feature is right under, below, or underneath the second feature or the first feature is obliquely under, below, or underneath the second feature, or the first feature is simply at a lower level than the second feature.

In the description of embodiments, orientations or position relations indicated by terms such as "upper", "lower", "left", and "right" are based on the drawings. These orientations or position relations are intended only to facilitate description and simplify an operation and not to indicate or imply that a device or element referred to must have such particular orientations or must be configured or operated in such particular orientations. Thus, these orientations or position relations are not to be construed as limiting the present application. In addition, terms "first" and "second" are used only to distinguish between descriptions and have no special meanings.

### Embodiment one

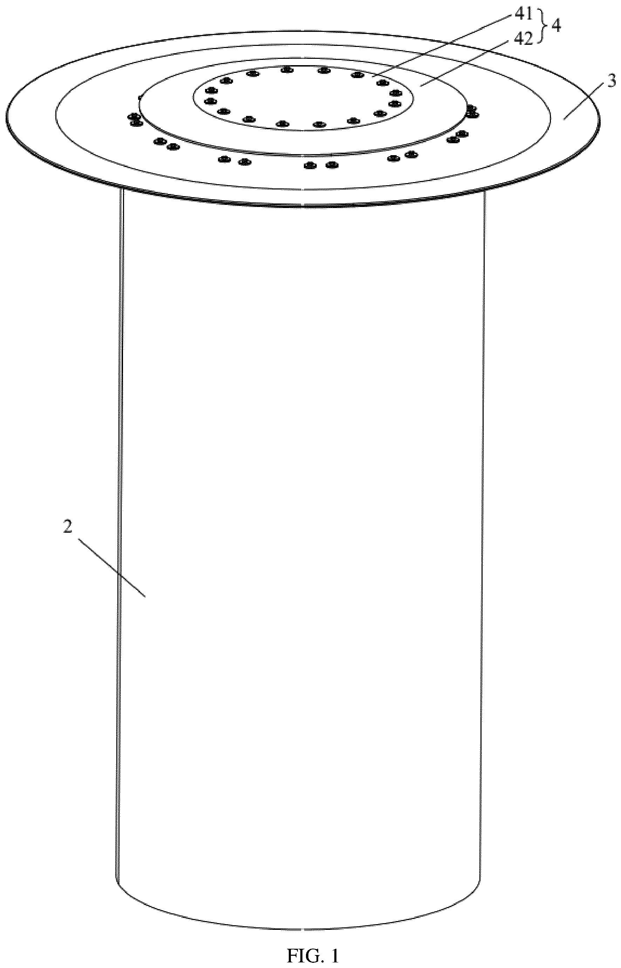

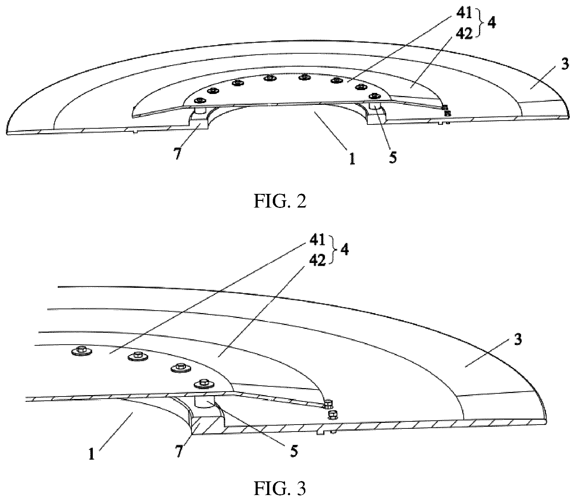

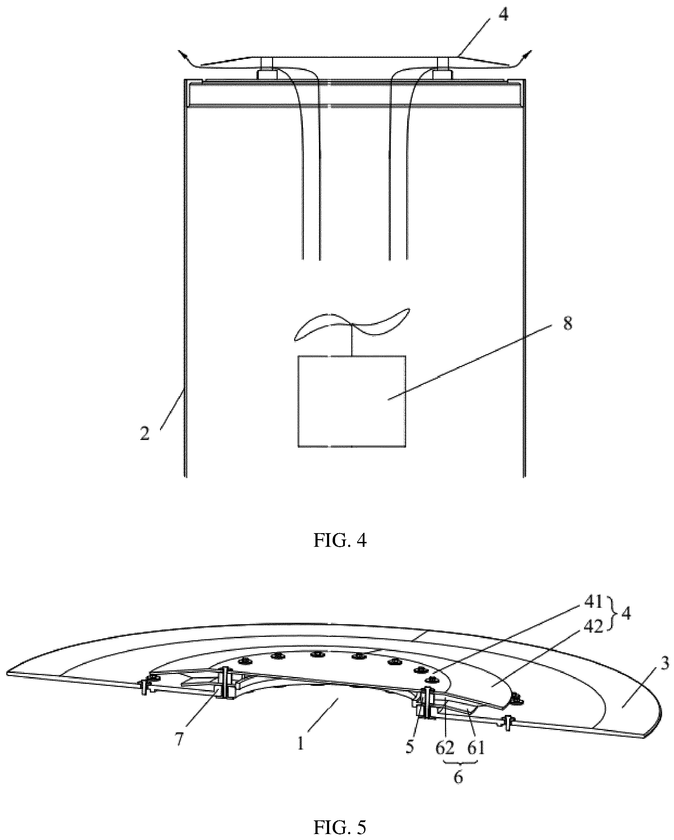

As shown in FIG. 1, the present embodiment provides a ventilation and heat dissipation apparatus for a wind-assisted rotor, which includes a cylinder 2, a top cover 3, and a rain shielding plate 4. As shown in FIGS. 2 and 3, the top cover 3 is disposed at the top of the cylinder 2 and covers the top of the cylinder 2, the top cover 3 is provided with a manhole 1**,** and the manhole 1 communicates with an inner cavity of the cylinder 2. The rain shielding plate 4 is disposed above the manhole 1 and covers the manhole 1, and the rain shielding plate 4 and the top cover 3 are spaced apart to form a heat dissipation gap that communicates with the external atmosphere. As shown in FIG. 4, the ventilation and heat dissipation apparatus for the wind-assisted rotor according to the present embodiment dissipates heat inside the cylinder 2 to the external atmosphere through the heat dissipation gap between the rain shielding plate 4 and the top cover 3 under the action of an exhaust fan 8. **In** case of rain and snow, the rain shielding plate 4 can prevent rain and snow from entering inside the cylinder 2, thus preventing an electric motor or other components in the cylinder 2 from being damaged by the rain and snow.

**In** one embodiment, multiple support columns 5 are used for supporting the rain shielding plate 4 above the manhole 1. The support columns 5 are detachably connected between the rain shielding plate 4 and the top cover 3. For example, the multiple support columns 5 are disposed at intervals in the circumferential direction of the top cover 3. With this structure, the multiple support columns 5 divide the heat dissipation gap into multiple sub-gaps, and the heat inside the cylinder 2 is dissipated to the external atmosphere through a sub-gap between two adjacent support columns 5. Optionally, the multiple support columns 5 are uniformly disposed between the rain shielding plate 4 and the top cover 3. **In** one aspect, the connection stability between the rain shielding plate 4 and the top cover 3 can be improved so that the rain shielding plate 4 can be stably and horizontally disposed above the manhole 1. **In** another aspect, the multiple support columns 5 are uniformly disposed so that the multiple sub-gaps have the same size, thereby achieving more uniform heat dissipation. **In** the present embodiment, the support columns 5 are fastened between the rain shielding plate 4 and the top cover 3 through bolts. **In** one aspect, when a component inside the cylinder 2 is damaged, maintenance personnel can quickly detach the rain shielding plate 4 and enter inside the cylinder 2 through the manhole 1 to perform maintenance. **In** another aspect, if the rain shielding plate 4 is eroded or damaged, the maintenance personnel can replace the rain shielding plate 4 in time. Optionally, to ensure that the support columns 5 can support the rain shielding plate 4 stably and improve the connection stability between the rain shielding plate 4 and the top cover 3, in the present embodiment, the number of support columns 5 is 16. In other embodiments, the number of support columns 5 may be designed according to actual conditions.

In one embodiment, the rain shielding plate 4 includes a first rain shielding plate 41 and a second rain shielding plate 42. The first rain shielding plate 41 is a circular plate disposed directly above the manhole 1. To increase a rain shielding area, the second rain shielding plate 42 is configured to be an annular slanted plate. A first end of the second rain shielding plate 42 is connected to the first rain shielding plate 41 at a first preset angle, and a second end of the second rain shielding plate 42 is slanted downward towards the top cover 3. With this structure, a certain heat dissipation gap still exists between the second rain shielding plate 42 and the top cover 3 in case that the heat inside the cylinder 2 cannot be dissipated to the external atmosphere in time. To increase the wind resistance strength of the rain shielding plate 4, optionally, in the present embodiment, the first rain shielding plate 41 and the second rain shielding plate 42 are integrally formed.

To prevent rainwater falling on the top cover 3 from flowing inside the cylinder 2 through the manhole 1, a rain blocking boss 7 is disposed on an inner rim of the top cover 3 corresponding to the manhole 1. Optionally, the rain blocking boss 7 is annular.

To prolong the service life of the ventilation and heat dissipation apparatus for the wind-assisted rotor in the present embodiment, a sunscreen and waterproof layer is coated on both a surface of the top cover 3 and a surface of the rain shielding plate 4.

In one embodiment, an insect screen is disposed between the rain shielding plate 4 and the top cover 3 so that foreign matters such as insects are prevented from falling inside the cylinder 2.

According to the ventilation and heat dissipation apparatus for the wind-assisted rotor in the present embodiment, the rain shielding plate 4 is disposed above the manhole 1 of the top cover 3 and covers the manhole 1, and the rain shielding plate 4 and the top cover 3 are spaced apart to form the heat dissipation gap that communicates with the external atmosphere so that the heat inside the cylinder 2 can be dissipated to the external atmosphere through the heat dissipation gap, and rain and snow can be prevented from entering inside the cylinder 2. The ventilation and heat dissipation apparatus for the wind-assisted rotor has a simple structure, a good ventilation and heat dissipation effect, and a low production cost and is suitable for practical applications.

### Embodiment two

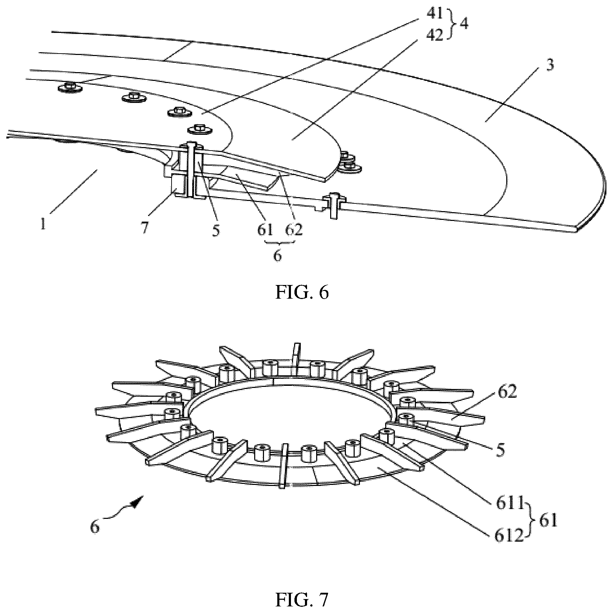

The present embodiment provides a ventilation and heat dissipation apparatus for a wind-assisted rotor. As shown in FIGS. 5 and 6, the ventilation and heat dissipation apparatus for the wind-assisted rotor differs from the ventilation and heat dissipation apparatus for the wind-assisted rotor in embodiment one only in that the ventilation and heat dissipation apparatus for the wind-assisted rotor in the present embodiment has a reinforcement assembly 6.

To further enhance the structural strength of the rain shielding plate 4 to cope with severe weather, the ventilation and heat dissipation apparatus for the wind-assisted rotor in the present embodiment may also include the reinforcement assembly 6. As shown in FIGS. 5 and 6, the reinforcement assembly 6 is disposed on the lower surface of the rain shielding plate 4 and disposed between the rain shielding plate 4 and the top cover 3. As shown in FIG. 7, the reinforcement assembly 6 includes a lining plate 61 and reinforcement ribs 62. The lining plate 61 is disposed between the rain shielding plate 4 and the top cover 3 so that the structural strength of the rain shielding plate 4 is enhanced and the rain shielding plate 4 assists in blocking rain and snow from entering inside the cylinder 2. A first end of a reinforcement rib 62 is fixedly connected to the lower surface of the rain shielding plate 4, and a second end of the reinforcement rib 62 is fixedly connected to the upper surface of the lining plate 61, thereby enhancing the connection strength between the rain shielding plate 4 and the lining plate 61.

Optionally, the reinforcement ribs 62 are connected to the rain shielding plate 4 and the lining plate 61 by welding. Optionally, to improve the structural strength of the rain shielding plate 4 and ensure that heat inside the cylinder 2 can be smoothly dissipated to the external atmosphere, the number of reinforcement ribs 62 is the same as the number of support columns 5, and the reinforcement ribs 62 and the support columns 5 are alternately disposed.

In one embodiment, as shown in FIG. 7, the lining plate 61 includes a first lining plate 611 and a second lining plate 612 which are connected at a second preset angle. Optionally, the first lining plate 611 is an annular plate and is disposed on the inner side of the second lining plate 612. The second lining plate 612 is an annular slanted plate, and an end of the second lining plate 612 facing away from the first lining plate 611 is slanted downward towards the top cover 3. In the present embodiment, the first preset angle is the same as the second preset angle so that the lining plate 61 has a relative good effect of assisting the rain shielding plate 4 in blocking rain and causes the heat inside the cylinder 2 to flow more smoothly to the external atmosphere, thereby improving heat dissipation efficiency.

To prevent stress concentration at a connection of the reinforcement rib 62 from damaging the rain shielding plate 4 or the lining plate 61, multiple reinforcement ribs 62 are provided, and the multiple reinforcement ribs 62 are uniformly disposed along the circumferential direction of the first lining plate 611. In this manner, the uniformity of connection forces is improved, and it is convenient to dissipate the heat inside the cylinder 2 to the external atmosphere through heat dissipation gaps between the support columns 5 and the reinforcement ribs 62.

To increase the wind resistance strength of the ventilation and heat dissipation apparatus for the wind-assisted rotor in the present embodiment, optionally, the first lining plate 611 and second lining plate 612 are integrally formed.

According to the ventilation and heat dissipation apparatus for the wind-assisted rotor in the present embodiment, the rain shielding plate 4 is disposed above the manhole 1 of the top cover 3 and covers the manhole 1, and the rain shielding plate 4 and the top cover 3 are spaced apart to form the heat dissipation gap that communicates with the external atmosphere so that the heat inside the cylinder 2 can be dissipated to the external atmosphere through the heat dissipation gap, and rain and snow can be prevented from entering inside the cylinder 2. The reinforcement assembly 6 is added so that the structural strength of the ventilation and heat dissipation apparatus is enhanced, and the effect of preventing rain and snow can be further enhanced. The ventilation and heat dissipation apparatus for the wind-assisted rotor has a simple structure, a good ventilation and heat dissipation effect, and a low production cost and is suitable for practical applications.

## Claims

1. A ventilation and heat dissipation apparatus for a wind-assisted rotor, comprising:
a cylinder (2);
a top cover (3) disposed at a top of the cylinder (2) and covering the top of the cylinder (2), wherein the top cover (3) is provided with a manhole (1) communicating with an inner cavity of the cylinder (2);
a rain shielding plate (4) disposed above the manhole (1) and covering the manhole (1), wherein the rain shielding plate (4) and the top cover (3) are spaced apart to form a heat dissipation gap that communicates with an external atmosphere; and
a reinforcement assembly (6), wherein the reinforcement assembly (6) is connected to a lower surface of the rain shielding plate (4), and the reinforcement assembly (6) and the rain shielding plate (4) are spaced apart to form a heat dissipation gap;
wherein the reinforcement assembly (6) comprises:
a lining plate (61) disposed between the rain shielding plate (4) and the top cover (3); and
reinforcement ribs (62), wherein a first end of each of the reinforcement ribs (62) is fixedly connected to the lower surface of the rain shielding plate (4), and a second end of the each of the reinforcement ribs (62) is fixedly connected to an upper surface of the lining plate (61);
the ventilation and heat dissipation apparatus for the wind-assisted rotor is **characterized in that** the lining plate (61) comprises a first lining plate (611) and a second lining plate (612) which are connected at a second preset angle, wherein the first lining plate (611) is an annular plate and is disposed on an inner side of the second lining plate (612), and the second lining plate (612) is an annular slanted plate, and an end of the second lining plate (612) facing away from the first lining plate (611) is slanted downward towards the top cover (3).

2. The ventilation and heat dissipation apparatus for the wind-assisted rotor according to claim 1, further comprising:
a plurality of support columns (5), wherein the plurality of support columns (5) are detachably connected between the rain shielding plate (4) and the top cover (3), and the plurality of support columns (5) are disposed at intervals in a circumferential direction of the top cover (3).

3. The ventilation and heat dissipation apparatus for the wind-assisted rotor according to claim 2, wherein the plurality of support columns (5) are uniformly disposed between the rain shielding plate (4) and the top cover (3).

4. The ventilation and heat dissipation apparatus for the wind-assisted rotor according to claim 2, wherein the plurality of support columns (5) are fastened between the rain shielding plate (4) and the top cover (3) through bolts.

5. The ventilation and heat dissipation apparatus for the wind-assisted rotor according to claim 1, wherein the rain shielding plate (4) comprises:
a first rain shielding plate (41) disposed directly above the manhole (1); and
a second rain shielding plate (42), which is an annular slanted plate, wherein a first end of the second rain shielding plate (42) is connected to the first rain shielding plate (41) at a first preset angle, and a second end of the second rain shielding plate (42) is slanted downward towards the top cover (3).

6. The ventilation and heat dissipation apparatus for the wind-assisted rotor according to claim 1, wherein a plurality of reinforcement ribs (62) are provided, and the plurality of reinforcement ribs (62) are uniformly disposed along a circumferential direction of the first lining plate (611).

7. The ventilation and heat dissipation apparatus for the wind-assisted rotor according to any one of claims 1 to 6, wherein a rain blocking boss (7) is disposed on an inner rim of the top cover (3) corresponding to the manhole (1), and the rain blocking boss (7) is annular and configured to prevent outside rainwater from flowing inside the cylinder (2).

## Patentansprüche

1. Eine Belüftungs- und Wärmeabfuhrvorrichtung für einen windunterstützten Rotor, umfassend:
einen Zylinder (2);
eine obere Abdeckung (3), die an einer Oberseite des Zylinders (2) angeordnet ist und die Oberseite des Zylinders (2) abdeckt, wobei die obere Abdeckung (3) mit einem Mannloch (1) versehen ist, das mit einem Innenraum des Zylinders (2) in Verbindung steht;
eine Regenschutzplatte (4), die oberhalb des Mannlochs (1) angeordnet ist und das Mannloch (1) abdeckt, wobei die Regenschutzplatte (4) und die obere Abdeckung (3) im Abstand zueinander angeordnet sind, um einen Wärmeabfuhrspalt zu bilden, der mit der Außenatmosphäre in Verbindung steht; und
eine Verstärkungsbaugruppe (6), wobei die Verstärkungsbaugruppe (6) mit einer unteren Oberfläche der Regenschutzplatte (4) verbunden ist, und wobei die Verstärkungsbaugruppe (6) und die Regenschutzplatte (4) im Abstand zueinander angeordnet sind, um einen Wärmeabfuhrspalt zu bilden;
wobei die Verstärkungsbaugruppe (6) umfasst:
eine Auskleidungsplatte (61), die zwischen der Regenschutzplatte (4) und der oberen Abdeckung (3) angeordnet ist; und
Verstärkungsrippen (62), wobei ein erstes Ende jeder der Verstärkungsrippen (62) fest mit der unteren Oberfläche der Regenschutzplatte (4) verbunden ist und ein zweites Ende jeder der Verstärkungsrippen (62) fest mit einer oberen Oberfläche der Auskleidungsplatte (61) verbunden ist;
wobei die Belüftungs- und Wärmeabfuhrvorrichtung für den windunterstützten Rotor **dadurch gekennzeichnet ist, dass** die Auskleidungsplatte (61) eine erste Auskleidungsplatte (611) und eine zweite Auskleidungsplatte (612) umfasst, die in einem zweiten vorgegebenen Winkel miteinander verbunden sind, wobei die erste Auskleidungsplatte (611) eine ringförmige Platte ist und auf einer Innenseite der zweiten Auskleidungsplatte (612) angeordnet ist, und wobei die zweite Auskleidungsplatte (612) eine ringförmige geneigte Platte ist, und ein von der ersten Auskleidungsplatte (611) abgewandtes Ende der zweiten Auskleidungsplatte (612) nach unten schräg in Richtung der oberen Abdeckung (3) geneigt ist.

2. Belüftungs- und Wärmeabfuhrvorrichtung für den windunterstützten Rotor nach Anspruch 1, ferner umfassend:
mehrere Stützsäulen (5), wobei die mehreren Stützsäulen (5) lösbar zwischen der Regenschutzplatte (4) und der oberen Abdeckung (3) verbunden sind und die mehreren Stützsäulen (5) in Umfangsrichtung der oberen Abdeckung (3) in Abständen angeordnet sind.

3. Belüftungs- und Wärmeabfuhrvorrichtung für den windunterstützten Rotor nach Anspruch 2, wobei die mehreren Stützsäulen (5) gleichmäßig zwischen der Regenschutzplatte (4) und der oberen Abdeckung (3) angeordnet sind.

4. Belüftungs- und Wärmeabfuhrvorrichtung für den windunterstützten Rotor nach Anspruch 2, wobei die mehreren Stützsäulen (5) mittels Bolzen zwischen der Regenschutzplatte (4) und der oberen Abdeckung (3) befestigt sind.

5. Belüftungs- und Wärmeabfuhrvorrichtung für den windunterstützten Rotor nach Anspruch 1, wobei die Regenschutzplatte (4) umfasst:
eine erste Regenschutzplatte (41), die direkt oberhalb des Mannlochs (1) angeordnet ist; und
eine zweite Regenschutzplatte (42), die eine ringförmige geneigte Platte ist, wobei ein erstes Ende der zweiten Regenschutzplatte (42) in einem ersten vorgegebenen Winkel mit der ersten Regenschutzplatte (41) verbunden ist und ein zweites Ende der zweiten Regenschutzplatte (42) nach unten schräg in Richtung der oberen Abdeckung (3) geneigt ist.

6. Belüftungs- und Wärmeabfuhrvorrichtung für den windunterstützten Rotor nach Anspruch 1, wobei mehrere Verstärkungsrippen (62) vorgesehen sind und die mehreren Verstärkungsrippen (62) gleichmäßig entlang einer Umfangsrichtung der ersten Auskleidungsplatte (611) angeordnet sind.

7. Belüftungs- und Wärmeabfuhrvorrichtung für den windunterstützten Rotor nach einem der Ansprüche 1 bis 6, wobei ein Regenabweisvorsprung (7) an einem Innenrand der oberen Abdeckung (3) vorgesehen ist, der dem Mannloch (1) zugeordnet ist, und wobei der Regenabweisvorsprung (7) ringförmig ist und dazu ausgebildet ist, zu verhindern, dass Regenwasser von außen in den Zylinder (2) eindringt.

## Revendications

1. Appareil de ventilation et de dissipation de chaleur pour un rotor à assistance éolienne, comprenant :
un cylindre (2) ;
un couvercle supérieur (3) disposé au sommet du cylindre (2) et couvrant le sommet du cylindre (2), le couvercle supérieur (3) étant pourvu d'un trou d'homme (1) en communication avec une cavité interne du cylindre (2) ;
une plaque anti-pluie (4) disposée au-dessus du trou d'homme (1) et couvrant le trou d'homme (1), la plaque anti-pluie (4) et le couvercle supérieur (3) étant espacés pour former un espace de dissipation de chaleur qui communique avec une atmosphère externe ; et
un ensemble de renforcement (6), l'ensemble de renforcement (6) étant connecté à une surface inférieure de la plaque anti-pluie (4), et l'ensemble de renforcement (6) et la plaque anti-pluie (4) étant espacés pour former un espace de dissipation de chaleur ;
dans lequel l'ensemble de renforcement (6) comprend :
une plaque de revêtement (61) disposée entre la plaque anti-pluie (4) et le couvercle supérieur (3) ; et
des nervures de renfort (62), la première extrémité de chacune des nervures de renfort (62) étant connectée de manière fixe à la surface inférieure de la plaque anti-pluie (4), et une deuxième extrémité de chacune des nervures de renfort (62) étant connectée de manière fixe à une surface supérieure de la plaque de revêtement (61) ;
l'appareil de ventilation et de dissipation de chaleur pour le rotor à assistance éolienne est **caractérisé en ce que** la plaque de revêtement (61) comprend une première plaque de revêtement (611) et une deuxième plaque de revêtement (612) qui sont connectées à un deuxième angle prédéfini, la première plaque de revêtement (611) étant une plaque annulaire et étant disposée sur un côté interne de la deuxième plaque de revêtement (612), et la deuxième plaque de revêtement (612) étant une plaque inclinée annulaire, et une extrémité de la deuxième plaque de revêtement (612) faisant face à l'opposé de la première plaque de revêtement (611) étant inclinée vers le bas vers le couvercle supérieur (3).

2. Appareil de ventilation et de dissipation de chaleur pour le rotor à assistance éolienne selon la revendication 1, comprenant, en outre :
une pluralité de colonnes de support (5), la pluralité de colonnes de support (5) étant connectées de manière détachable entre la plaque anti-pluie (4) et le couvercle supérieur (3), et la pluralité de colonnes de support (5) étant disposées à intervalles dans une direction circonférentielle du couvercle supérieur (3).

3. Appareil de ventilation et de dissipation de chaleur pour le rotor à assistance éolienne selon la revendication 2, dans lequel la pluralité de colonnes de support (5) est disposée uniformément entre la plaque anti-pluie (4) et le couvercle supérieur (3).

4. Appareil de ventilation et de dissipation de chaleur pour le rotor à assistance éolienne selon la revendication 2, dans lequel la pluralité de colonnes de support (5) est fixée entre la plaque anti-pluie (4) et le couvercle supérieur (3) au moyen de boulons.

5. Appareil de ventilation et de dissipation de chaleur pour le rotor à assistance éolienne selon la revendication 1, dans lequel la plaque anti-pluie (4) comprend :
une première plaque anti-pluie (41) disposée directement au-dessus du trou d'homme (1) ; et
une deuxième plaque anti-pluie (42), laquelle est une plaque inclinée annulaire, la première extrémité de la deuxième plaque anti-pluie (42) étant connectée à la première plaque anti-pluie (41) à un premier angle prédéfini, et la deuxième extrémité de la deuxième plaque anti-pluie (42) étant inclinée vers le bas vers le couvercle supérieur (3).

6. Appareil de ventilation et de dissipation de chaleur pour le rotor à assistance éolienne selon la revendication 1, dans lequel une pluralité de nervures de renfort (62) sont fournies, et la pluralité de nervures de renfort (62) sont disposées uniformément le long d'une direction circonférentielle de la première plaque de revêtement (611).

7. Appareil de ventilation et de dissipation de chaleur pour le rotor à assistance éolienne selon l'une quelconque des revendications 1 à 6, dans lequel un bossage pare-pluie (7) est disposé sur un bord interne du couvercle supérieur (3) correspondant au trou d'homme (1), et le bossage pare-pluie (7) est annulaire et configuré pour empêcher l'eau de pluie extérieure de couler à l'intérieur du cylindre (2).
